# EUROPÄISCHE PATENTANMELDUNG

(11) **EP 4 560 607 A1**
(43) Veröffentlichungstag der Anmeldung: **28.05.2025**
(21) Anmeldenummer: 24208820.1
(22) Anmeldetag: 25.10.2024
(51) Int. Cl.: G09F 7/16, G09F 13/04, G09F 13/08, G09F 23/00, F21V 8/00, G09F 13/22

(54) **ELEKTRISCHES GERÄT MIT LEUCHTANZEIGE**

(30) Priorität: 23.11.2023 DE 102023132754
(71) Anmelder: Murrelektronik GmbH, 71570 Oppenweiler (DE)
(72) Erfinder: Roolf, Tim, 71570 Oppenweiler (DE); Feißt, Heiko, 71570 Oppenweiler (DE); Ruf, Henrik, 71570 Oppenweiler (DE)
(74) Vertreter: Prinz & Partner mbB

(57) **Zusammenfassung**

Die Erfindung betrifft ein elektrisches Gerät (10) mit einer Leuchtanzeige (14, 16), umfassend ein Gehäuse (18) und eine im Gehäuse (18) angeordnete Lichtquelle (22), die eingerichtet ist, Licht in eine Gehäusewand (20) des Gehäuses (18) einzukoppeln, das sich durch das Material der Gehäusewand (20) zu einem lichtauskoppelnden Teil (24) des Gehäuses (18) ausbreitet, durch welchen das von der Lichtquelle (22) ausgesendete Licht aus dem Gehäuse (18) austreten kann, wobei die Leuchtanzeige (14, 16) durch zumindest den lichtauskoppelnden Teil (24) des Gehäuses (18) gebildet ist, wobei der lichtauskoppelnde Teil (24) des Gehäuses (18) oder ein nichtlichtauskoppelnder Teil (26) des Gehäuses (18), der den lichtauskoppelnden Teil (24) des Gehäuses (18) begrenzt, durch eine lokale mechanische, chemische und/oder physikalische Behandlung des Gehäuses (18) hergestellt worden ist, wobei die Behandlung in einem vollständig montierten Zustand des elektrischen Geräts (10) erfolgt. Ferner betrifft die Erfindung ein Verfahren zum Herstellen des elektrischen Geräts (10).

## Beschreibung

Die Erfindung betrifft ein elektrisches Gerät mit einer Leuchtanzeige sowie ein Verfahren zu dessen Herstellung.

In den aus dem Stand der Technik bekannten elektrischen Geräten werden zur Signalisierung von Betriebszuständen oft Leuchtdioden eingesetzt. Beispielsweise können Zustände wie die Energieversorgung ("Power on"), Fehler oder spezifische Funktionen angezeigt werden. Zur Realisierung der Leuchtanzeige werden in das Gehäuse, welches das elektrische Gerät umgibt und schützt, entsprechende Durchbrüche eingebracht, denen entweder die Leuchtdioden direkt oder Lichtleiter zugeordnet sind, die mit den Leuchtdioden zusammenwirken.

Spezielle Anzeigesymbole können beispielsweise durch Masken erzeugt werden, die zumeist aus einer undurchsichtigen Schicht gefertigt sind. Diese Schicht kann z.B. eine Farbschicht sein oder aus einem gelochten bzw. gestanzten Material bestehen.

Konventionelle Leuchtanzeigen werden üblicherweise durch werkzeuggebundene Teile hergestellt. Dabei wird für jede neue optische Ausprägung der Leuchtanzeige ein individuell angepasstes Werkzeug benötigt. So müssen entweder die Lichtleiter in der entsprechenden Form hergestellt und in das Gehäuse integriert werden oder bereits im Gehäuse befindliche Lichtleiter teilweise, z.B. durch Drucken, insbesondere Tampondruck, abgedeckt werden. Da dies technisch kompliziert ist, können vor allem kleine Losgrößen bzw. Sonderprodukte mit einem individualisierten Anzeigebild oft nicht wirtschaftlich sinnvoll umgesetzt werden.

Die Aufgabe der Erfindung ist es daher, ein elektrisches Gerät mit einer technisch einfach zu implementierenden Leuchtanzeige bereitzustellen, das auch in kleinen bis mittleren Losgrößen kostengünstig hergestellt werden kann.

Die Aufgabe wird erfindungsgemäß gelöst durch ein elektrisches Gerät mit einer Leuchtanzeige, umfassend ein Gehäuse und eine im Gehäuse angeordnete Lichtquelle. Die Lichtquelle ist dazu eingerichtet, Licht in eine Gehäusewand des Gehäuses einzukoppeln, das sich durch das Material der Gehäusewand zu einem lichtauskoppelnden Teil des Gehäuses ausbreitet, durch welchen das von der Lichtquelle ausgesendete Licht aus dem Gehäuse austreten kann. Die Leuchtanzeige ist durch zumindest den lichtauskoppelnden Teil des Gehäuses gebildet. Dabei ist der lichtauskoppelnde Teil des Gehäuses oder ein nichtlichtauskoppelnder Teil des Gehäuses, der den lichtauskoppelnden Teil des Gehäuses begrenzt, durch eine lokale mechanische, chemische und/oder physikalische Behandlung des Gehäuses hergestellt worden, wobei die Behandlung in einem vollständig montierten Zustand des elektrischen Geräts erfolgt.

Unter einem "vollständig montierten Zustand" ist dabei zu verstehen, dass sämtliche Bestandteile des elektrischen Geräts bereits miteinander verbunden sind, also mechanisch und/oder elektrisch verbunden sind. Mit anderen Worten sind im vollständig montierten Zustand zumindest die Hardware-Komponenten im Gehäuse vollständig enthalten. Das Konfigurieren des elektrischen Geräts und/oder das Aufspielen einer Software, insbesondere einer individualisierten Software, gehört in diesem Sinne nicht zur Montage und kann auch noch nach der Herstellung der Leuchtanzeige des erfindungsgemäßen elektrischen Geräts erfolgen.

Der Grundgedanke der Erfindung ist es, die Leuchtanzeige erst im vollständig montierten Zustand des elektrischen Geräts herzustellen, ohne dabei das Gehäuse zu durchbrechen, also eine Durchbrechung bzw. eine durchgehende Öffnung im Gehäuse herzustellen. Auch muss das Gehäuse nachträglich nicht geöffnet werden. Dadurch wird einerseits eine gute Individualisierbarkeit der Leuchtanzeige erreicht und andererseits sichergestellt, dass die im Gehäuse aufgenommenen Komponenten des elektrischen Geräts durch das Gehäuse stets ausreichend geschützt sind, insbesondere vor Feuchtigkeit.

Zudem ist es hierdurch möglich, die elektrischen Geräte in einem Grundzustand in großen Mengen herzustellen. Anschließend kann das jeweilige, sich im Grundzustand befindliche elektrische Gerät, was vollständig montiert ist, hinsichtlich der Leuchtanzeige, insbesondere des lichtauskoppelnden Teils, individuell an den Kunden angepasst werden. Hierdurch ergeben sich entsprechend kurze Herstellungsdauern und geringe Herstellungskosten von Sonderprodukten oder kleinen Losgrößen.

Insbesondere wird durch diese Art der Herstellung gewährleistet, dass je nach Gerätetyp oder Anwendung geforderte Schutzstandards eingehalten werden, beispielsweise der Schutzstandard IP44, IP67 und/oder IP 69K, der für zahlreiche Geräte gefordert wird.

In einer Ausführungsvariante ist vorgesehen, dass der lichtauskoppelnde Teil des Gehäuses durch eine Veränderung der Gehäusewand ausgebildet ist. Der Innenraum des elektrischen Geräts und darin angeordnete elektrische bzw. elektronische Komponenten bzw. Bauteile bleiben somit während der Behandlung geschützt, insbesondere auch vor Rückständen, die sich bei der Behandlung selbst bilden können, beispielsweise Späne oder Dampf.

Das Material der Gehäusewand kann ein Kunststoffmaterial sein, das Additive aufweist, die dazu ausgebildet sind, durch die mechanische, chemische und/oder physikalische Behandlung die optischen Eigenschaften des Materials lokal zu verändern, um den lichtauskoppelnden Teil des Gehäuses auszubilden, insbesondere in einer definierten Weise. Durch die Additive kann eine gewünschte Individualisierung der Leuchtanzeige in definierter Weise erfolgen, da die Additive beispielsweise von einem Laser angeregt werden, um einen Transluzenzgrad einzustellen. Ferner kann das Kunststoffmaterial aufweisende Gehäuse schnell und kostengünstig gefertigt werden, beispielsweise durch Spritzgießen.

Vorzugsweise sind der lichtauskoppelnde Teil des Gehäuses und der nichtlichtauskoppelnde Teil des Gehäuses stofflich durchgehend miteinander verbunden. Dadurch werden mögliche Schwachstellen am Übergang der beiden Teile vermieden.

In einer Variante des elektrischen Geräts umfasst zumindest der lichtauskoppelnde Teil des Gehäuses wenigstens einen optischen Streuer. Der optische Streuer streut das in der Gehäusewand auf ihn treffende Licht, wodurch eine effektive Lichtauskopplung aus der Gehäusewand erreicht werden kann.

Bei dem wenigstens einen optischen Streuer kann es sich um eine dreidimensionale Struktur handeln, die durch die Behandlung in die Gehäusewand eingebracht worden ist, z.B. eine Aussparung in der Gehäusewand. Alternativ kann es sich bei dem wenigstens einen optischen Streuer um einen durch die Behandlung in das Gehäuse eingebrachten materialveränderten Bereich handeln. So kann z.B. durch eine Laserbehandlung Kunststoffmaterial der Gehäusewand lokal verändert werden (teilzersetzt, kristallisiert etc.), wodurch opake Bereiche in der Gehäusewand gebildet werden, welche das Licht streuen und so die Lichtauskopplung aus dem Gehäuse ermöglichen oder verbessern.

Grundsätzlich können auch die zuvor genannten Additive als Störer der Gehäusestruktur angesehen werden, an denen eine Lichtreflektion bzw. Streuung des in das Gehäuse eingekoppelten Lichts erfolgt. Demnach können die Additive (zusätzlich) auch als Streuer fungieren. Es kann sich im Bereich der Additive der lichtauskoppelnde Teil ergeben.

Weiterhin ist denkbar, dass das Gehäuse einen Innenraum des elektrischen Gerätes vollumfänglich und/oder allseitig umschließt, sodass sämtliche vorgesehene elektrische bzw. elektronische Bauteile/Komponenten von dem Gehäuse aufgenommen sind. Lediglich ein Anschluss oder mehrere Anschlüsse sind außenseitig am Gehäuse angebracht, um das elektrische Gerät anzuschließen bzw. mit anderen Geräten zu verbinden. Dadurch wird ein besonders guter Schutz der elektronischen Bauteile gewährleistet und ein hoher Schutzstandard erreicht.

Die Aufgabe der Erfindung wird ferner gelöst durch ein Verfahren zum Herstellen eines erfindungsgemäßen elektrischen Gerätes mit den Schritten:
- Bereitstellen eines elektrischen Geräts in einem fertig montierten Zustand, das ein Gehäuse aufweist, in dem sämtliche elektrische bzw. elektronische Bauteile des elektrischen Geräts aufgenommen sind;
- Herstellen eines lichtauskoppelnden Teils des Gehäuses durch eine lokale mechanische, chemische und/oder physikalische Behandlung des Gehäuses im fertig montierten Zustand.

Die Vorteile, die zum elektrischen Gerät diskutiert wurden, gelten für das erfindungsgemäße Verfahren in gleicher Weise.

In einer Variante des Verfahrens ist vorgesehen, dass die Behandlung des Gehäuses durch ein mechanisches Entfernen und/oder eine Laserablation einer opaken Deckschicht des Gehäuses erfolgt. Alternativ oder zusätzlich kann die lokale Behandlung des Gehäuses durch eine selektive Belichtung erfolgen, insbesondere mittels Laser, wodurch sich die optischen Eigenschaften des Materials des Gehäuses verändern. Beispielsweise können so lokale Lichtstreuer in der Gehäusewand erzeugt werden und/oder das Material des Gehäuses so verändert werden, dass es opaker oder transparenter wird. Alle diese Maßnahmen können auf das vollständig montierte elektrische Gerät angewendet werden, um schnell und kostengünstig eine Leuchtanzeige in der Gehäusewand zu implementieren, ohne dazu das Gehäuse durchbrechen zu müssen bzw. einen Durchbruch in das Gehäuse einzubringen.

Außerdem ist denkbar, dass vor oder nach dem Herstellen des lichtauskoppelnden Teils des Gehäuses nur noch eine Software aufgespielt wird, die dem lichtauskoppelnden Teil des Gehäuses zugeordnet ist, um das einsatzbereite elektrische Gerät herzustellen. So kann technisch einfach ein individualisiertes elektrisches Gerät kostengünstig hergestellt und auch als solches anhand des lichtauskoppelnden Teils des Gehäuses bzw. der Leuchtanzeige erkannt werden.

Die kostengünstige Herstellung des individualisierten elektrischen Geräts ist möglich, da die elektrischen Geräte zunächst in großen Mengen (großes Los) in einem Grundzustand hergestellt werden, also im vollständig montierten Zustand, in dem alle elektrischen und/oder elektronischen Bauteile bereits im Gehäuse aufgenommen sind. Anschließend kann das vollständig montierte elektrische Gerät hinsichtlich der Leuchtanzeige, insbesondere des lichtauskoppelnden Teils, individuell an den Kunden angepasst werden, also individualisiert werden. Die Werkzeuge für die Herstellung der elektrischen Geräte sind jedoch gleich, da mit den Werkzeugen das elektrische Gerät in seinem Grundzustand hergestellt wird, also im vollständig montierten Zustand.

Mit anderen Worten ist es für die gewünschte Individualisierung nicht notwendig, separate Werkzeuge zur Herstellung vorzusehen, wodurch die Kosten kleiner Mengen (geringes Los bzw. Sonderprodukte) entsprechend hoch wären.

Weitere Merkmale und Vorteile der Erfindung ergeben sich aus der nachfolgenden Beschreibung sowie aus den Zeichnungen, auf die Bezug genommen wird. In den Zeichnungen zeigen:
- Fig. 1 eine schematische dreidimensionale Darstellung eines erfindungsgemäßen elektrischen Geräts gemäß einer beispielhaften Ausführungsform;
- Fig. 2 eine schematische dreidimensionale Darstellung eines Herstellungsschritts eines lichtauskoppelnden Gehäuseteils des erfindungsgemäßen elektrischen Geräts durch Laserbehandlung;
- Fig. 3 eine schematische dreidimensionale Darstellung eines Herstellungsschritts eines lichtauskoppelnden Gehäuseteils des erfindungsgemäßen elektrischen Geräts durch mechanische Bearbeitung;
- Fig. 4 eine schematische Schnittdarstellung eines Abschnittes des Gehäuses des erfindungsgemäßen elektrischen Geräts mit einer Aussparung, die als Streuer wirkt; und
- Fig. 5 eine schematische Schnittdarstellung eines Abschnittes des Gehäuses des erfindungsgemäßen elektrischen Geräts mit optischen Streuern innerhalb der Gehäusewand.

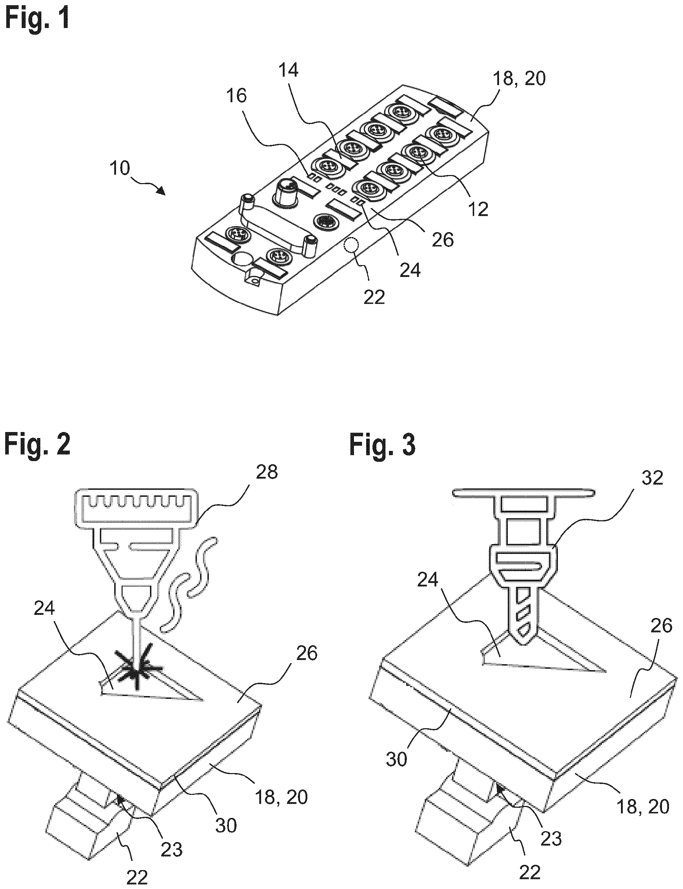

Figur 1 zeigt eine schematische dreidimensionale Darstellung eines erfindungsgemäßen elektrischen Geräts 10. Im gezeigten Ausführungsbeispiel ist das elektrische Gerät 10 ein Elektronikmodul, insbesondere für Industrieanwendungen.

Das elektrische Gerät 10 weist mehrere Anschlüsse 12 sowie anschlussspezifische Leuchtanzeigen 14 auf, also Leuchtanzeigen 14, über die ein Zustand des zugeordneten Anschlusses 12 angezeigt werden kann. Darüber hinaus weist das elektrische Gerät 10 auch eine modulspezifische Leuchtanzeige 16 auf, die beispielsweise Informationen über eine Konfiguration oder Software des elektrischen Geräts 10 anzeigen kann, also allgemein eine Information bezüglich des gesamten elektrischen Geräts 10.

Die äußere Hülle des elektrischen Geräts 10 ist durch ein Gehäuse 18 mit einer Gehäusewand 20 gebildet. Im Ausführungsbeispiel besteht das Gehäuse 18 aus einem transparenten spritzgegossenen Kunststoffmaterial. Außenseitig ist das Gehäuse 18 bzw. die Gehäusewand 20 zumindest teilweise opak beschichtet, beispielsweise lackiert.

Das Gehäuse 18 umschließt das elektrische Gerät 10 bis auf Öffnungen für die Anschlüsse 12 vollumfänglich und allseitig.

In dem Gehäuse 18 sind sämtliche elektrische/elektronische Bauteile bzw. Komponenten des elektrischen Geräts 10 aufgenommen. Dadurch werden sie von Umgebungseinflüssen wie Staub oder Feuchtigkeit geschützt.

Zur Realisierung der Leuchtanzeige 16 weist das elektrische Gerät 10 im Inneren des Gehäuses 18 eine Lichtquelle 22 auf, beispielsweise eine Leuchtdiode oder ein Leuchtdiodenarray.

Im Ausführungsbeispiel ist die Lichtquelle 22 dazu ausgebildet und eingerichtet, Licht in die Gehäusewand 20 des Gehäuses 18 einzukoppeln. Das Einkoppeln des Lichts in das Gehäuse 18, kann beispielsweise durch eine Seitenwand und/oder einen speziell ausgeformten Einkoppelbereich 23 des Gehäuses 18 erfolgen. Auch kann ein Lichtleiter vorgesehen sein, mit dem Licht von der Lichtquelle 22 zum Einkoppelbereich 23 des Gehäuses 18 geleitet wird. Das über den Einkoppelbereich 23 des Gehäuses 18 eingekoppelte Licht breitet sich dann durch das Material der Gehäusewand 20 aus.

Die Gehäusewand 20 weist einen lichtauskoppelnden Teil 24 auf, der die Leuchtanzeige 16 bildet und durch welchen das sich in der Gehäusewand 20 ausbreitende Licht der Lichtquelle 22 aus der Gehäusewand 20 austreten kann.

Ferner weist die Gehäusewand 20 einen nichtlichtauskoppelnden Teil 26 auf, beispielsweise aus opakem oder opak beschichtetem Kunststoff, der den lichtauskoppelnden Teil 24 des Gehäuses 18 begrenzt.

Durch die Form, die Größe und/oder die Zuordnung des lichtauskoppelnden Teils 24 und des nichtlichtauskoppelnden Teils 26 lassen sich Symbole und ähnliches an der Außenseite des Gehäuses 18 realisieren.

Der lichtauskoppelnde Teil 24 und der nichtlichtauskoppelnde Teil 26 sind im Ausführungsbeispiel als ein durchgehendes Spritzgussbauteil ausgebildet und somit stofflich miteinander verbunden, also stoffschlüssig ausgebildet. Dadurch ist der Übergang der beiden Teile 24, 26 besonders robust.

Im Ausführungsbeispiel ist der lichtauskoppelnde Teil 24 des Gehäuses 18 in einem vollständig montierten Zustand des elektrischen Geräts 10 durch eine lokale Behandlung des Gehäuses 18 mit einem Laser 28 hergestellt worden, also nachdem bereits alle elektrischen bzw. elektronischen Bauteile in dem Gehäuse 18 eingebracht worden sind. Die elektrischen bzw. elektronischen Bauteile sind dabei sowohl mechanisch als auch elektrisch angebunden worden.

Der Herstellungsschritt der lokalen Behandlung ist schematisch in Figur 2 gezeigt.

Wie anhand der Darstellung ersichtlich, wird der lichtauskoppelnde Teil 24 des Gehäuses 18 durch eine lokale Veränderung der Gehäusewand 20 ausgebildet, nämlich durch ein bereichsweises Abtragen einer opaken Deckschicht 30 des Gehäuses 18. Vorzugsweise befindet sich die Deckschicht 30 dabei gehäuseaußenseitig. Alternativ kann sie aber auch gehäuseinnenseitig angebracht sein.

Die Deckschicht 30 selbst kann durch verschiedene Verfahren aufgebracht worden sein, insbesondere durch ein Zweikomponentenspritzgussverfahren, eine Lackierung, eine Bedruckung oder eine Folierung durch Heißsiegeln oder In-Mould-Labeling (IML).

Alternativ kann der lichtauskoppelnde Teil 24 des Gehäuses 18 in einem vollständig montierten Zustand des elektrischen Geräts 10 auch durch eine lokale chemische Behandlung oder mechanische Bearbeitung des Gehäuses 18 hergestellt worden sein.

Figur 3 zeigt eine solche mechanische Behandlung bzw. Bearbeitung, in der eine opake Deckschicht 30 des Gehäuses 18 mittels eines Fräswerkzeuges 32 entfernt wird, um das darunterliegende transparente Kunststoffmaterial bereichsweise freizulegen.

Die in Figur 2 und 3 gezeigten Arten der Behandlung des Gehäuses 18 sind selbstverständlich nicht einschränkend zu verstehen. Auch ein Materialabtrag durch Wasserstrahlgravur oder Hobeln oder ähnlichem ist denkbar.

Es ist auch möglich, dass das Gehäuse 18 aus einem Material, besteht, das Additive aufweist, die dazu ausgebildet sind, durch die mechanische, chemische und/oder physikalische Behandlung die optischen Eigenschaften des Materials lokal zu verändern, um den lichtauskoppelnden Teil 24 des Gehäuses 18 auszubilden. Mit anderen Worten wird die Transluzenz der Additive beispielsweise durch eine Laserbestrahlung verändert, wodurch der Bereich, in dem die Additive vorgesehen sind, opaker oder transparenter wird, was letztendlich vom verwendeten Laser und/oder den Additiven abhängt.

Beispielsweise kann es sich bei dem Material um einen Kunststoff handeln, dessen Opazität durch eine Behandlung mit einem Laser 28 lokal gezielt von transparent bis vollständig opak eingestellt werden kann, insbesondere durch eine Anregung der enthaltenen Additive. So lassen sich auch hinterleuchtete Symbole und/oder Schriftzüge in der Leuchtanzeige 16 schnell und einfach fertigen.

Der lichtauskoppelnde Teil 24 des Gehäuses 18 kann ferner auch dadurch gebildet sein, dass durch die Behandlung lokale Störstellen und/oder optische Streuer 34 in die Gehäusewand 20 eingebracht worden sind, welche das Licht aus der Gehäusewand 20 auskoppeln. Auch die Additive könnten - sofern gewünscht - als solche Streuer 34 fungieren.

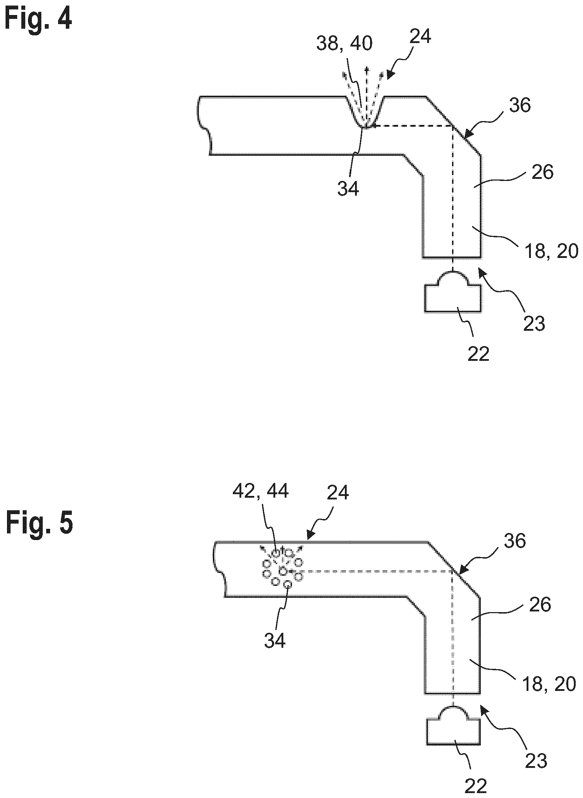

In Figur 4 ist eine Schnittdarstellung eines Abschnittes eines Gehäuses 18 gezeigt, in den Licht der Lichtquelle 22 in die Gehäusewand 20 eingekoppelt wird, insbesondere über eine Seitenwand des Gehäuses 18. Die Gehäusewand 20 ist dabei durch die Materialauswahl und Konstruktion so beschaffen, dass das eingekoppelte Licht zum lichtauskoppelnden Teil 24 des Gehäuses 18 geleitet wird. Insofern kann das Licht an einer Stelle des Gehäuses 18 eingekoppelt werden, die beabstandet zum lichtauskoppelnden Teil 24 des Gehäuses 20 ist. Mit anderen Worten ist der Einkoppelbereich 23 vom lichtauskoppelnden Teil 24 beabstandet. Das Gehäuse 18 bzw. das Gehäusematerial stellt also einen Lichtleiter dar.

Der lichtauskoppelnden Teil 24 befindet sich beispielsweise an einer Frontseite des Gehäuses 18. Das Gehäuse 18 weist im Ausführungsbeispiel eine Oberfläche 36 auf, an der das eingekoppelte Licht reflektiert wird. Die Oberfläche 36, welche daher auch als Reflexionsfläche bezeichnet werden kann, ist im gezeigten Ausführungsbeispiel in einem Winkel von 45° zur Seitenwand sowie zur Frontseite des Gehäuses 18 ausgerichtet. Aufgrund des Winkels sowie der Lichtbrechungseigenschaften des Gehäusematerials tritt an der Oberfläche 36 Totalreflexion auf, sodass das eingekoppelte Licht (im Wesentlichen) vollständig von der Seitenwand an die Frontseite des Gehäuses 18 geleitet wird, wie dies in Figur 4 gezeigt ist.

Das Gehäuse 18 kann also so ausgelegt sein, dass bereichsweise eine Totalreflexion des eingekoppelten Lichts innerhalb der Gehäusewand 20 stattfindet. So kann ein Lichtstrom in der Gehäusewand 20 erzeugt werden, der (unabhängig von der Einkopplung) parallel zur Anzeigenebene verläuft. Der Einkoppelbereich 23 und der lichtauskoppelnde Teil 24 des Gehäuses 20 können also örtlich voneinander getrennt sein.

In dem in Figur 4 gezeigten Beispiel erfolgt die Lichtauskopplung durch eine dreidimensionale Struktur 38 (vorliegend eine Aussparung 40), welche durch eine lokale Behandlung (beispielsweise durch Fräsen, Gravur oder durch ein Prägen mittels Nadeln) in der der Gehäusewand 20 bzw. einem Oberflächenabschnitt der Gehäusewand 20 geschaffen wurde und an der Licht gestreut wird. Durch die Streuung kann zumindest ein Teil des Lichtstroms aus dem Gehäuse 18 ausgekoppelt werden.

Alternativ oder zusätzlich können auch in das Gehäuse 18 eingebrachte materialveränderte Bereiche 42 vorgesehen sein, die als optische Streuer 34 wirken. Dies ist in Figur 5 schematisch gezeigt. Wie vorstehend erläutert, kann es sich bei den Streuern 34 auch um Additive handeln.

Bei den materialveränderten Bereichen 42 kann es sich beispielsweise um teilzersetzte, oder teilkristallisierte opake Stellen 44 in einer ansonsten transparenten Kunststoffmatrix handeln, welche durch die lokale Behandlung gezielt geschaffen worden sind, beispielsweise durch Bestrahlen der Additive.

Durch die definiert eingebrachten Streuer 34 lassen sich sehr exakte Ausleitungen aus dem Lichtstrom der Gehäusewand 20 erzeugen und sehr feine Symbole oder Schriftzüge herstellen. Vorteilhaft an dieser Art der Lichtauskopplung ist weiterhin, dass es zu keiner oder nur einer sehr geringen Schwächung des Gehäusematerials kommt. Zudem ergibt sich eine durchgehende Außenfläche des Gehäuses 18, sodass sich keine Ablagerungen ansammeln können. Aus diesem Grund eignet sich diese Methode insbesondere für Anwendungsbereiche, in denen Sauberkeit und Reinheit von enormer Bedeutung sind, beispielsweise im Lebensmittelbereich oder im Pharmabereich.

Das in Figur 1 gezeigte elektrische Gerät 10 mit Leuchtanzeige 16 ist durch ein Ausführungsbeispiel eines erfindungsgemäßen Verfahrens hergestellt worden. Das Verfahren und dessen Schritte werden nachfolgend kurz erläutert.

In einem ersten Schritt des Verfahrens wird ein elektrisches Geräts 10 in einem fertig montierten Zustand bereitgestellt, das ein Gehäuse 18 aufweist, in dem sämtliche elektronische/elektrische Bauteile des elektrischen Geräts 10 aufgenommen sind. Die Hardware ist also bereits vollständig installiert, sodass das elektrische Gerät 10 in einem Grundzustand vorliegt, der für alle elektrischen Geräte 10 gleich ist, sodass ein Werkzeug bzw. ein Werkzeugset zur Herstellung der elektrischen Geräte 10 ausreichend ist.

In einem zweiten Schritt des Verfahrens wird ein lichtauskoppelnder Teil 24 des Gehäuses 18 durch eine lokale mechanische, chemische und/oder physikalische Behandlung des Gehäuses 18 im fertig montierten Zustand hergestellt, also in dem Zustand, in dem die Hardware vollständig installiert ist.

Die lokale Behandlung des Gehäuses 18 kann, wie bereits anhand der Figuren 2 und 3 erläutert, durch ein mechanisches Entfernen und/oder ein Laserabtragen einer opaken Deckschicht 30 des Gehäuses 18 erfolgen.

Alternativ oder zusätzlich kann die lokale Behandlung des Gehäuses 18 durch eine selektive Belichtung erfolgen, insbesondere mittels Laser 28, wodurch sich die optischen Eigenschaften des Materials des Gehäuses 18 verändern. So ist denkbar, dass die Opazität eines Gehäuses 18 aus einem Kunststoffmaterial mit speziellen laseraktiven Additiven durch die Laserbehandlung lokal gezielt verändert wird, um lichtauskoppelnde Teile 24 und/oder nichtlichtauskoppelnde Teile 26 des Gehäuses 18 zu definieren und so die Leuchtanzeige 16 auszubilden.

In einem weiteren Schritt des Verfahrens kann vor oder nach dem Herstellen des lichtauskoppelnden Teils 24 des Gehäuses 18 noch eine Software auf das elektrische Gerät 10 aufgespielt werden. Die aufzuspielende Software kann insbesondere dem lichtauskoppelnden Teil 24 des Gehäuses 18 zugeordnet sein, um zu gewährleisten, dass in bestimmten Betriebszuständen das Licht über den lichtauskoppelnden Teil 24 des Gehäuses 18 ausgekoppelt wird, also die Lichtquelle 22 entsprechend angesteuert wird. Beispielsweise kann die Leuchtanzeige 16 derart ausgebildet sein, dass sie den durch die Software definierten Gerätetyp und/oder die Gerätefunktion angibt.

**Bezugszeichenliste**

| Bezugszeichen | Benennung |
|---|---|
| | |
| 10 | elektrisches Gerät |
| 12 | Anschluss |
| 14 | anschlussspezifische Leuchtanzeige |
| 16 | modulspezifische Leuchtanzeige |
| 18 | Gehäuse |
| 20 | Gehäusewand |
| 22 | Lichtquelle |
| 23 | Einkoppelbereich |
| 24 | lichtauskoppelnder Teil |
| 26 | nichtlichtauskoppelnder Teil |
| 28 | Laser |
| 30 | Deckschicht |
| 32 | Fräswerkzeug |
| 34 | Streuer |
| 36 | Oberfläche |
| 38 | Struktur |
| 40 | Aussparung |
| 42 | materialveränderter Bereich |
| 44 | opake Stelle |

## Patentansprüche

1. Elektrisches Gerät mit einer Leuchtanzeige (14, 16), umfassend ein Gehäuse (18) und eine im Gehäuse (18) angeordnete Lichtquelle (22), die eingerichtet ist, Licht in eine Gehäusewand (20) des Gehäuses (18) einzukoppeln, das sich durch das Material der Gehäusewand (20) zu einem lichtauskoppelnden Teil (24) des Gehäuses (18) ausbreitet, durch welchen das von der Lichtquelle (22) ausgesendete Licht aus dem Gehäuse (18) austreten kann, wobei die Leuchtanzeige (14, 16) durch zumindest den lichtauskoppelnden Teil (24) des Gehäuses (18) gebildet ist, wobei der lichtauskoppelnde Teil (24) des Gehäuses (18) oder ein nichtlichtauskoppelnder Teil (26) des Gehäuses (18), der den lichtauskoppelnden Teil (24) des Gehäuses (18) begrenzt, durch eine lokale mechanische, chemische und/oder physikalische Behandlung des Gehäuses (18) hergestellt worden ist, wobei die Behandlung in einem vollständig montierten Zustand des elektrischen Geräts (10) erfolgt.

2. Elektrisches Gerät nach Anspruch 1, wobei der lichtauskoppelnde Teil (24) des Gehäuses (18) durch eine Veränderung der Gehäusewand (20) ausgebildet ist.

3. Elektrisches Gerät nach Anspruch 1 oder 2, wobei das Material der Gehäusewand (20) ein Kunststoffmaterial ist, das Additive aufweist, wobei die Additive dazu ausgebildet sind, durch die mechanische, chemische und/oder physikalische Behandlung die optischen Eigenschaften des Materials lokal zu verändern, um den lichtauskoppelnden Teil (24) des Gehäuses (18) auszubilden.

4. Elektrisches Gerät nach einem der vorhergehenden Ansprüche, wobei der lichtauskoppelnde Teil (24) des Gehäuses (18) und der nichtlichtauskoppelnde Teil (26) des Gehäuses (18) stofflich durchgehend miteinander verbunden sind.

5. Elektrisches Gerät nach einem der vorhergehenden Ansprüche, wobei zumindest der lichtauskoppelnde Teil (24) des Gehäuses (18) wenigstens einen optischen Streuer (34) umfasst.

6. Elektrisches Gerät nach Anspruch 5, wobei der wenigstens eine optische Streuer (34) eine dreidimensionale Struktur (38) ist, die durch die Behandlung in die Gehäusewand (20) eingebracht worden ist, insbesondere eine Aussparung (40), und/oder wobei der wenigstens eine optische Streuer (34) ein durch die Behandlung in das Gehäuse (18) eingebrachte materialveränderte Bereich (42) ist.

7. Elektrisches Gerät nach einem der vorhergehenden Ansprüche, wobei das Gehäuse (18) einen Innenraum des elektrischen Gerätes (10) vollumfänglich und/oder allseitig umschließt, sodass sämtliche vorgesehene elektronische Bauteile von dem Gehäuse (18) aufgenommen sind.

8. Verfahren zum Herstellen eines elektrischen Gerätes (10) gemäß einem der vorhergehenden Ansprüche, umfassend die Schritte:
- Bereitstellen eines elektrischen Geräts (10) in einem fertig montierten Zustand, das ein Gehäuse (18) aufweist, in dem sämtliche elektrische und/oder elektronische Bauteile des elektrischen Geräts (10) aufgenommen sind;
- Herstellen eines lichtauskoppelnden Teils (24) des Gehäuses (18) durch eine lokale mechanische, chemische und/oder physikalische Behandlung des Gehäuses (18) im fertig montierten Zustand.

9. Verfahren nach Anspruch 8, wobei die lokale Behandlung des Gehäuses (18) durch ein mechanisches Entfernen und/oder eine Laserablation einer opaken Deckschicht (30) des Gehäuses (18) erfolgt und/oder wobei die lokale Behandlung des Gehäuses (18) durch eine selektive Belichtung, insbesondere mittels eines Lasers (28), erfolgt, durch die sich die optischen Eigenschaften des Materials des Gehäuses (18) verändern.

10. Verfahren nach Anspruch 8 oder 9, wobei vor oder nach dem Herstellen des lichtauskoppelnden Teils (24) des Gehäuses (18) nur noch eine Software aufgespielt wird, die dem lichtauskoppelnden Teil (24) des Gehäuses (18) zugeordnet ist, um das einsatzbereite elektrische Gerät (10) herzustellen.
